# EUROPEAN PATENT APPLICATION

(11) **EP 1 926 137 A2**
(43) Date of publication of application: **28.05.2008**
(21) Application number: 07022117.1
(22) Date of filing: 14.11.2007
(51) Int. Cl.: H01L 21/56

(54) **Heat-resistant adhesive tape for manufacturing semiconductor device**

(30) Priority: 24.11.2006 JP 2006317581
(71) Applicant: Nitto Denko Corporation, Ibaraki-shi, Osaka 567-8680 (JP)
(72) Inventor: Amano, Yasuhiro, Ibaraki-shi Osaka (JP); Kondo, Hiroyuki, Ibaraki-shi Osaka (JP); Okeyui, Takuji, Ibaraki-shi Osaka (JP); Terada, Yoshio, Ibaraki-shi Osaka (JP)
(74) Representative: HOFFMANN EITLE

(57) **Abstract**

The present invention provides a heat-resistant adhesive tape for manufacturing a semiconductor device usable in a method for manufacturing a semiconductor device including at least the steps of mounting a semiconductor chip on a die pad of a metallic lead frame in which a heat-resistant adhesive tape is adhered to an outer pad side to bond the semiconductor chip thereto, subjecting a semiconductor chip side to a single-sided encapsulation with an encapsulating resin, and dicing the encapsulated constructed product to individual semiconductor devices, characterized in that the heat-resistant adhesive tape comprises a substrate layer, and an adhesive layer containing a hydrophilic layered silicate and an adhesive.

## Description

### BACKGROUND OF THE INVENTION

### Field of the Invention

The present invention relates to a heat-resistant adhesive tape used in the manufacture of a semiconductor device.

### Discussion of the Related Art

In recent years, in the techniques of mounting LSI, CSP (Chip Size/Scale Package) techniques have been remarked. Of the techniques mentioned above, a package in the form in which a lead end is incorporated into the internal of the package as represented by a QFN (Quad Flat Non-leaded package) is one of the package forms especially remarked from the aspects of miniaturization and high integration. Among the methods for manufacturing a QFN as described above, in recent years, a manufacturing method in which plural chips for QFN are arranged in order on a die pad in the package pattern region of the lead frame, and encapsulated in a single batch with an encapsulating resin within cavities of a die, and thereafter cut out to individual QFN constructions by dicing, thereby dramatically improving the productivity per area of the lead frame has been especially remarked.

In the method of manufacturing QFN comprising batch-encapsulating plural semiconductor chips as described above, a region clamped with a molding die upon the resin encapsulation is only in the outside of the resin encapsulation region, which is further spread outside of the package pattern region. Therefore, the package pattern region, especially in its central part, cannot press the outer lead side to the molding die with a sufficient pressure, thereby making it very difficult to suppress leakage of the encapsulating resin to the outer lead side, whereby making it more likely to cause a disadvantage that a terminal or the like of QFN is covered with the resin.

Therefore, in the method for manufacturing QFN as described above, it is considered that a manufacturing method that prevents the leakage of the resin to the outer lead side upon the resin encapsulation by a sealing effect by putting the heat-resistant adhesive tape with the outer lead side of the lead frame, and utilizing self-adhesion (masking) of this heat-resistant adhesive tape is especially effective.

In the manufacturing method as described above, putting the adhesive tape with the outer lead side after mounting semiconductor chips on the lead frame, or after carrying out wire bonding is in effect difficult from the aspect of handling. Therefore, it is desired that the heat-resistant adhesive tape is put with the outer pad side of the lead frame in an initial stage, and thereafter being put together until an encapsulating step with an encapsulating resin after going through a mounting step of semiconductor chips and a wire bonding step. Therefore, in the heat-resistance adhesive tape, properties that satisfy all these steps, such as not only the prevention of leakage of the encapsulating resin, but also a high level of heat resistance that is durable in the mounting step of the semiconductor chips or no hindrance in delicate operations in the wire bonding step are required. As a tape satisfying this requirement, a heat-resistant adhesive tape has been developed (Japanese Patent Laid-Open No. 2004-14930).

However, it is difficult for an adhesive to exhibit its conventional adhesive properties at a high temperature at which the steps such as wire bonding, resin encapsulation, and the like are carried out, so that the adhesive strength to the object to be adhered is drastically lowered. Therefore, the adhesive tape is undesirably removed from the object to be adhered due to impact or the like upon wire bonding. Consequently, there may be a disadvantage such as the encapsulating resin leaks between the lead frame and the adhesive tape upon the resin encapsulation in some cases.

### SUMMARY OF THE INVENTION

According to the present invention, there is provided a heat-resistant adhesive tape for manufacturing a semiconductor device usable in a method for manufacturing a semiconductor device including at least the steps of mounting a semiconductor chip on a die pad of a metallic lead frame in which a heat-resistant adhesive tape is adhered to an outer pad side to bond the semiconductor chip thereto, subjecting a semiconductor chip side to a single-sided encapsulation with an encapsulating resin, and dicing the encapsulated constructed product to individual semiconductor devices, characterized in that the heat-resistant adhesive tape contains a substrate layer, and an adhesive layer containing a hydrophilic layered silicate and an adhesive.

### BRIEF DESCRIPTION OF THE DRAWINGS

Figure 1 is a schematic view of a series of steps of one example of the method for manufacturing a semiconductor device;
Figure 2 is a schematic view of one example of a lead frame, wherein (a) is a front view, (b) is a partially enlarged view, and (c) is a vertical cross-section showing the state after the resin encapsulation; and
Figure 3 is a vertical cross-section showing one example of a resin encapsulating step according to the present invention.

In the figures, the numerals denote as follows:
**10** is a lead frame, **11** a package pattern region, **11a** an opening, **11b** a terminal portion, **11c** a die pad, **11d** a damber, **12** a cavity, **13** a hole for a guide pin, **15** a semiconductor chip, **15a** an electrode pad, **16** a bonding wire, **17** an encapsulating resin, **17a** a diced part, **18** a die, **18a** an upper die, **18b** a lower die, **19** an electro-conductive paste, **20** a heat-resistant adhesive tape, **20a** a substrate layer, **20b** an adhesive layer, **21** an encapsulated construction, and **21a** a semiconductor device.

### DETAILED DESCRIPTION OF THE INVENTION

The present invention has been made in view of the above disadvantages, and an object of the present invention is to provide a heat-resistance adhesive tape capable of manufacturing a semiconductor device, the heat-resistance adhesive tape suitably preventing resin leakage in the encapsulation step, and being less likely to cause any troubles in the series of steps and the step of removing the tape, especially in a large-scaled matrix pattern type in which a large number of packages can be simultaneously encapsulated among the miniature QFN in the recent years.

The present inventors have intensively studied on the physical properties, the materials, the thickness and the like of the heat-resistant adhesive tape in order to solve the conventional disadvantages mentioned above. As a result, the present inventors have found that the above object can be accomplished by using a heat-resistant adhesive tape comprising a substrate layer and an adhesive layer containing a hydrophilic layered silicate and an adhesive. The present invention has been accomplished thereby.

It is preferable that the heat-resistant adhesive tape used in the above-mentioned method for manufacturing a semiconductor device has an adhesive strength of 0.2 N/19 mm width or more as determined at 175°C.

It is preferable that the heat-resistant adhesive tape usable in the above-mentioned method for manufacturing a semiconductor device has an adhesive strength of 5.0 N/19 mm width or less as determined as prescribed in JIS Z0237 in a case where a side of the adhesive layer is adhered to a stainless plate and heated at 200°C for 1 hour. The determination is carried out at a normal temperature (23°C).

The heat-resistant adhesive tape of the present invention can suitably prevent resin leakage in the encapsulation step, and the cohesive strength of the adhesive is increased by using a hydrophilic layered silicate, so that the adhesive strength of the object to be adhered can be retained under temperature conditions in the steps of manufacturing a semiconductor. In addition, the adhesive tape can be removed without causing any pasty residues on the object to be adhered even after a high-temperature heat treatment of 200°C or so. Further, the amount of gas generated can be reduced by using a water-dispersible acrylic adhesive containing a copolymer emulsion that is less likely to be degraded even under a high-temperature heat treatment. By the reduction in the amount of gas generated, the contamination of semiconductor chips can be suppressed, and the removal strength can be reduced, thereby making its removability excellent, whereby no pasty residues are generated on the object to be adhered. According to the heat-resistance adhesive tape, a semiconductor device in which the heat-resistance adhesive tape suitably prevents resin leakage in the encapsulation step, and is less likely to cause any troubles in the series of steps and the step of removing the tape, can be manufactured.

These and other advantages of the present invention will be apparent from the following description.

The heat-resistant adhesive tape of the present invention comprises a substrate layer and an adhesive layer containing a hydrophilic layered silicate and an adhesive. The material for the substrate layer is not particularly limited, so long as the material can be formed as a substrate portion of the adhesive layer. The material includes, for example, resin materials such as polyimide (PI) films, polyethylene terephthalate (PET) films, polyethylene naphthalate (PEN) films, polyether sulfone (PES) films, poly(ether imide) (PEI) films, polysulfone (PSF) films, polyphenylene sulfide (PPS) films, poly(ether ether ketone) (PEEK) films, polyarylate (PAR) films, aramide films, and liquid crystal polymers.

The substrate layer has a thickness of preferably 5 µm or more, in order to prevent the substrate layer from being bent or cracked, and more preferably a thickness of from 10 to 100 µm in view of suitable handling ability.

A feature of the adhesive layer in the present invention resides in that the adhesive layer contains a hydrophilic layered silicate and an adhesive.

The above-mentioned adhesive layer contains a hydrophilic layered silicate. The hydrophilic layered silicate refers to a clay mineral having a crystal structure in which clay layers mainly having two-dimensional structures are laminated. In addition, the hydrophilic layered silicate has not only properties of being allowed to swell by adding a solvent thereto, thereby increasing each of interlayer distances, but also properties of being capable of incorporating ions and molecules into the interlayer while keeping its structure. The hydrophilic layered silicate used in the present invention is not particularly limited, so long as the hydrophilic layered silicate can be dispersed in a water-dispersible acrylic adhesive. The hydrophilic layered silicate includes, smectite, saponite, sauconite, stevensite, hectorite, margarite, talc, phlogopite, chrysotile, chlorites, vermiculite, kaolinite, muscovite, xanthophyllite, dickite, nacrite, pyrophyllite, montmorillonite, beidellite, nontronite, tetrasilicic mica, sodium tenorite, antigorite, halloysite, and the like. The above-mentioned hydrophilic layered silicate may be any one of natural products or synthetic products. These hydrophilic layered silicates can be used alone or in admixture of two or more kinds.. Especially, those having an average length of preferably from 0.01 to 100 µm, and more preferably from 0.05 to 10 µm, and an aspect ratio of preferably from 20 to 500, and more preferably from 50 to 200 can be suitably used.

The amount of the above-mentioned hydrophilic layered silicate contained is not particularly limited, and the amount is properly determined depending upon the object to be adhered so that the resulting adhesive layer acquires heat resistance. For example, in the heat-resistance adhesive tape of the present invention, the hydrophilic layered silicate is usually contained in the adhesive layer in an amount of preferably 40 parts by weight or less, and more preferably 30 parts by weight or less, based on 100 parts by weight of the adhesive, whereby the heat resistance can be exhibited. The amount of the hydrophilic layered silicate is 40 parts by weight or less, from the viewpoint of maintaining the adhesive properties of the adhesive, and the amount of the hydrophilic layered silicate is 1 part by weight or more, and more preferably 10 parts by weight or more, from the viewpoint of exhibiting heat resistance. Therefore, it is desired that the adjustment is made according to the removal strength taking into account of the above amount as a measure. Here, the adhesive containing the hydrophilic layered silicate refers to one, for example, composed only of an adhesive.

Also, the adhesive usable in the adhesive layer in the present invention is not particularly limited so long as the adhesive has heat resistance, and includes, for example, acrylic adhesives, rubber-based adhesives, silicone-based adhesives, and the like. Further, as the acrylic adhesive, a water-dispersible acrylic adhesive or the like can be suitably used.

The water-dispersible acrylic adhesive usable in the present invention contains an alkyl (meth)acrylic ester of which alkyl moiety has 4 to 12 carbon atoms as a main component, and contains a copolymer emulsion obtainable by emulsion polymerization of a monomer containing a carboxyl group-containing monomer in the presence of an emulsifying agent.

The alkyl (meth)acrylic ester of which alkyl moiety has 4 to 12 carbon atoms is an ester formed between acrylic acid or methacrylic acid and an alcohol having 4 to 12 carbon atoms, and specific examples thereof include butyl (meth)acrylate, 2-ethylhexyl (meth)acrylate, isononyl (meth)acrylate, lauryl (meth)acrylate, cyclopentyl (meth)acrylate, cyclohexyl (meth)acrylate, isobornyl (meth)acrylate, and the like. These alkyl (meth)acrylic esters can be used alone or in admixture of two or more kinds.

Among the monomers constituting the copolymer emulsion, which is a component of the water-dispersible acrylic adhesive, besides the alkyl (meth)acrylic ester of which alkyl moiety has 4 to 12 carbon atoms, for the purpose of accomplishing at least one of improving adhesive strength to an object to be adhered, introducing cross-linking points for post-cross-linking the resulting copolymer emulsion, increasing cohesive force of the adhesive, and improving mechanical stability by neutralization, a carboxyl group-containing monomer is contained as a copolymerizable, functional group-containing monomer. The carboxyl group-containing monomer includes acrylic acid, methacrylic acid, itaconic acid, maleic acid, crotonic acid, and the like. These carboxyl group-containing monomers can be used alone or in admixture of two or more kinds.

In addition, for the purpose of accomplishing at least one of improving adhesive strength to an object to be adhered, introducing cross-linking points for post-cross-linking the resulting copolymer emulsion, and increasing the cohesive strength of the adhesive, a monomer containing a functional group other than a carboxyl group copolymerizable to the above-mentioned component or a modifying monomer may be used.

Other monomers containing a functional group other than the carboxyl group mentioned above include hydroxyl group-containing monomers such as 2-hydroxyethyl (meth)acrylate, 2-hydroxypropyl (meth)acrylate, and 2-hydroxybutyl (meth)acrylate; amide group-containing monomers such as (meth)acrylamide, N,N-dimethyl (meth)acrylamide, N-methylol (meth)acrylamide, N-methoxymethyl (meth)acrylamide, and N-butoxymethyl (meth)acrylamide; amino group-containing monomers such as 2-(N,N-dimethylamino)ethyl (meth)acrylate; glycidyl group-containing monomers such as glycidyl (meth)acrylate; alkoxysilyl group-containing monomers such as propyl trimethoxysilane (meth)acrylate, propyl dimethoxysilane (meth)acrylate and propyl triethoxysilane (meth)acrylate; (meth)acrylonitrile; N-(meth)acryloyl morpholine; N-vinyl-2-pyrrolidone; and the like. These functional group-containing monomers can be used alone or in admixture of two or more kinds.

The above-mentioned modifying monomer includes alkyl (meth)acrylic ester of which alkyl moiety has 1 to 3 carbon atoms, such as methyl (meth)acrylate, ethyl (meth)acrylate, and isopropyl (meth)acrylate; alkyl (meth)acrylic ester of which alkyl moiety has 13 to 18 carbon atoms, such as tridecyl (meth)acrylate and stearyl (meth)acrylate; vinyl acetate; styrene; vinyltoluene; and the like. In addition, the modifying monomer includes those having two or more polymerizable functional groups such as neopentyl glycol di(meth)acrylate, hexanediol di(meth)acrylate, propylene glycol di(meth)acrylate, trimethylolpropane tri(meth)acrylate, tetramethylolmethane tetra(meth)acrylate, and dipentaerythritol hexa(meth)acrylate, and the like. These modifying monomers can be used alone or in admixture of two or more kinds.

The monomers are used in a proportion of preferably 50 parts by weight or less, more preferably 20 parts by weight or less, and even more preferably from 0.5 to 10 parts by weight, based on 100 parts by weight of the adhesive composed only of, for example, the hydrophilic layered silicate, when the alkyl (meth)acrylic ester of which alkyl group has 4 to 12 carbon atoms and the carboxyl group-containing monomer satisfy the above purpose, and these monomers are added as a total of the all the containing monomers used of the carboxyl group-containing monomer, the monomer containing a functional group other than the carboxyl group, and the modifying monomer.

As the emulsifying agent used upon the emulsion polymerization of the water-dispersible acrylic adhesive, anionic emulsifying agents and nonionic emulsifying agents usable in the emulsion polymerization can be used without particular limitation. The emulsifying agent includes, for example, anionic emulsifying agents such as sodium lauryl sulfate, ammonium lauryl sulfate, sodium dodecylbenzenesulfonate, sodium polyoxyethylene alkyl sulfate, sodium polyoxyethylene alkyl ether sulfate, and sodium polyoxyethylene alkylphenyl ether sulfate; nonionic emulsifying agents such as polyoxyethylene alkyl ether and polyoxyethylene alkylphenyl ether; and the like. It is desired that the emulsifying agent is added, based on 100 parts by weight of the adhesive composed only of, for example, the hydrophilic layered silicate, in an amount of preferably from 0.2 to 10 parts by weight, and more preferably from 0.5 to 5 parts by weight.

The water-dispersible acrylic adhesive usable in the present invention contains the above-mentioned copolymer emulsion as a component for the main agent, and the water-dispersible acrylic adhesive can contain a cross-linking agent as occasion demands. The cross-linking agent includes, for example, isocyanate-based cross-linking agents, epoxy-based cross-linking agents, hydrazyl-based compounds, and the like. The amount of the cross-linking agent contained is not particularly limited. However, when the overall adhesive layer is too soft, sufficient affixture of the adhesive tape to the lead frame is hindered by the elastic strength of the adhesive even when a bonding wire is tried to be connected upon wire bonding, whereby consequently self-adhesive energy is undesirably tempered by pressing, so that there is a risk of undesirable generation of bonding failure. The cross-linking agent is added in an amount of preferably from 0.1 to 15 parts by weight, and more preferably from 1.0 to 10 parts by weight, based on 100 parts by weight of the water-dispersible acrylic adhesive containing, for example, the hydrophilic layered silicate and the above-mentioned copolymer emulsion. The water-dispersible acrylic adhesive containing the copolymer emulsion as described above is a most suitable adhesive in the present invention, because appropriate adhesive strength and shearing storage modulus can be easily obtained. In addition, since the copolymer emulsion-containing, water-dispersible acrylic adhesive in the present invention is less likely to degrade under high-temperature conditions, the amount of gas generated can be suppressed, and the staining or damage of the semiconductor chips can be prevented.

Also, it is preferable that the adhesive constituting the heat-resistant adhesive tape has a certain level of elasticity, from the aspect of its adhesive function. On the other hand, when the overall adhesive layer is too soft, sufficient affixture of the adhesive tape to the lead frame is hindered by the elastic strength of the adhesive even when a bonding wire is tried to be connected upon wire bonding, whereby consequently self-adhesive energy is undesirably tempered by pressing, so that there is a risk of undesirable generation of bonding failure.

In order to secure contradictory properties of not causing bonding failure and securing a sufficient adhesive strength that can prevent resin leakage in the encapsulation step, it is preferable that the adhesive has a shearing storage modulus at 200°C of preferably 1.0 × 10⁴ Pa or more, and more preferably 1.0 × 10⁵ Pa or more, as determined with a viscoelastic spectrometer at a frequency of 1 Hz and a heating rate of 5°C/minute, thereby making it possible to have only a slight cushioning property as an overall adhesive layer, whereby an excellent wire bonding strength can be obtained. Also, from the viewpoint of maintaining the step height follow-up property of the heat-resistant adhesive tape to the lead frame, thereby preventing the encapsulating resin from bleeding upon molding, the adhesive has a shearing storage modulus mentioned above of preferably 1.0 × 10⁸ Pa or less, and more preferably 0.5 × 10⁸ Pa or less.

The thickness of the adhesive layer in the present invention is not particularly limited. An exceedingly thick construction is not preferred in order to keep the cushioning property as the overall adhesive layer upon wire bonding to a very low level. On the other hand, a certain thickness is necessary to obtain sufficient sealing ability in the encapsulation step. It is suitable that the adhesive layer that can accomplish both the contradictory properties as described above in good balance is preferably from 1 to 50 µm, and more preferably from 5 to 25 µm.

The heat-resistant adhesive tape of the present invention is produced by forming an adhesive layer directly on a substrate layer, or indirectly transferring an adhesive layer formed on a separator to a substrate layer. In order to prepare the heat-resistant adhesive tape as described above, an adhesive may be subjected to a thin-layer coating to a substrate or a separator, and drying the coating. In addition, The term " heat-resistant" modifying the adhesive tape of the present invention refers to a state in which no residues of the adhesive can be visually observed upon removing an adhesive tape from an object to be adhered after a heating process.

The above-mentioned heat-resistant adhesive tape usable in the method for manufacturing a semiconductor device has an adhesive strength of preferably 0.2 N/19 mm width or more, more preferably 0.3 N/19 mm width or more, and even more preferably 0.5 N/19 mm width or more, at 175°C as determined by a method prescribed in JIS Z0237, from the viewpoint of maintaining excellent adhesive strength, thereby preventing abrasion of the adhesive tape from the object to be adhered.

The above-mentioned heat-resistant adhesive tape of the present invention has an adhesive strength of 5.0 N/19 mm width or less at 23°C, as determined by a method prescribed in JIS Z0237, in a case where a side of the adhesive layer is put together and adhered to a stainless plate and heated at 200°C for 1 hour, in which case the adhesive strength necessary for preventing resin leakage in the encapsulation step can be surely obtained, and at the same time the removal of the adhesive tape after the encapsulation step is facilitated, so that cracks in the encapsulating resin are not generated. The adhesive tape has the adhesive strength mentioned above of more preferably 2.0 N/19 mm width or less, from the viewpoint that the adhesive strength between the adhesive layer and the lead frame or the encapsulating resin is flexible enough so that the surface layer of the adhesive layer would not be detained in the perfected package upon removal of the adhesive layer, thereby obtaining an excellent package. The adhesive tape has the adhesive strength mentioned above of more preferably 0.05 N/19 mm width or more, and even more preferably 0.1 N/19 mm width or more, in order to favorably prevent resin leakage in the encapsulation step.

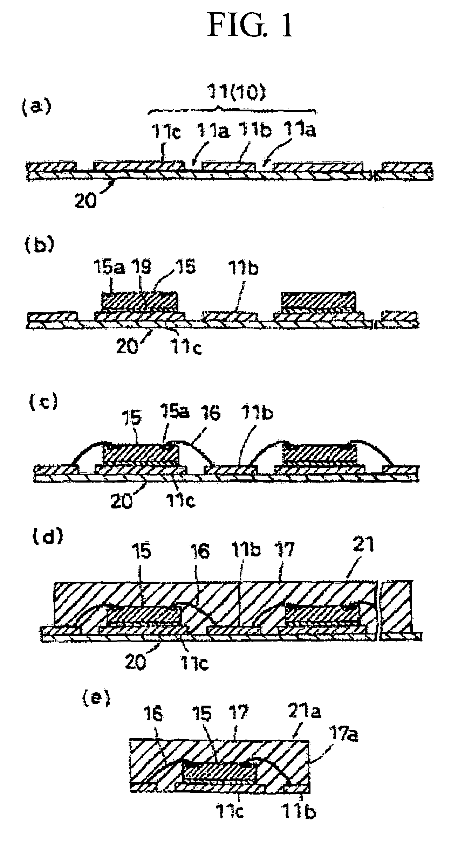

Next, the manufacture of a semiconductor device using the heat-resistant adhesive tape of the present invention will be explained referring to the drawings. Figure 1 is a schematic view of a series of steps of one example of the method for manufacturing a semiconductor device.

The method for manufacturing a semiconductor device in the present invention, as shown in Figure 1, including at least the steps of mounting a semiconductor chip **15**, encapsulating with an encapsulating resin **17**, and dicing the encapsulated constructed product **21**.

The mounting step, as shown in Figures 1(a) and (b), including the step of bonding a semiconductor chip **15** on a die pad **11c** of a metallic lead frame **10** in which a heat-resistant adhesive tape **20** is adhered to an outer pad side (lower side of each figure).

The lead frame **10** refers to one made of, for example, a metal such as copper as a material, in which terminal patterns of QFN are engraved, and the parts of electrically connected points thereof may be coated (plated) with a material made of silver, nickel, palladium, gold, or the like in some cases. The lead frame **10** generally has a thickness of from 100 to 300 µm. Here, the parts thinly worked partially with etching or the like are not bound to the numerical range mentioned above.

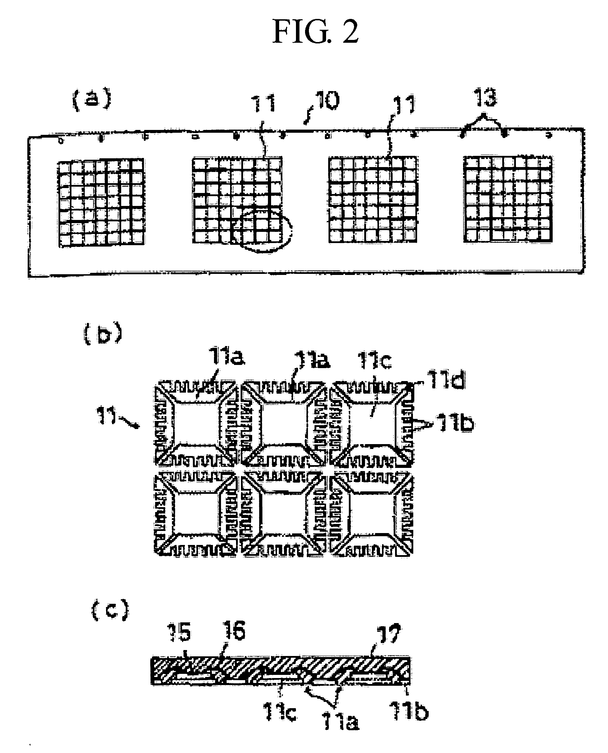

It is preferable that the lead frame **10** contains individual arranged patterns of QFN in a regular manner so that the arranged patterns can be easily diced in the subsequent dicing step. For example, as shown in Figure 2, a shape in which the patterns are arranged on the lead frame **10** in a grid-like matrix form or the like is so-called a matrix QFN or MAP-QFN, or the like, which is one of most preferred shape for the lead frame. Especially in recent years, in order to increase the number of packages arranged in a single lead frame from the viewpoint of productivity, not only these individual packages are miniatured, but also the number of arrangements of these packages is significantly extended, so that a large number of packages can be encapsulated in a single encapsulation part.

As shown in Figure 2 (a) and (b), in a package pattern region **11** of the lead frame **10**, a substrate design of QFN is arranged in a regular manner, in which plural terminal portions **11b** are arranged in adjoining plural openings **11a.** In a general QFN, each of substrate designs (region zoned with grids in Figure 2 (a)) comprises an opening **11a,** terminal portions **11b** having an outer lead side on a lower side and being arranged in the periphery of the opening **11a,** a die pad **11c** positioned at the center of the opening **11a,** and a damber **11d** for supporting the die pad **11c** at four comers of the opening **11a.**

The heat-resistant adhesive tape **20** is adhered from the outer side than at least the package pattern region **11**, and it is preferable that the adhesive tape **20** is adhered to a region including the entire periphery of the outer side of the resin encapsulating region to be resin-encapsulated. The lead frame **10** comprises a hole **13** for a guiding pin arranged near the edge for positioning upon resin encapsulation, and it is preferable that the adhesive tape **20** is adhered to a region that would not clog the hole **13** for a guiding pin. In addition, since the resin encapsulating region is arranged in plurality in the length direction of the lead frame **10**, it is preferable that the heat-resistant adhesive tape **20** is adhered in a manner that the adhesive tape **20** is carried on continuously over those plural regions.

A semiconductor chip **15**, i.e. a silicon wafer chip, which is a semiconductor integrated circuit portion, is mounted on the lead frame **10** as described above. An affixture area called a die pad **11c** for affixing this semiconductor chip **15** is provided on the lead frame **10**. As a method of bonding (affixing) to this die pad **11c**, various methods using, for example, an electro-conductive paste **19**, an adhesive tape, an adhesive or the like are employed. In a case where die bonding is carried out using an electro-conductive paste, a thermosetting adhesive, or the like, thermal curing is carried out at a temperature of 150° to 200°C or so for 30 to 90 minutes or so.

In generally, subsequent to the above step, a connecting step including the step of electrically connecting a tip end of the terminal portion of the above-mentioned lead frame and an electrode pad on the above-mentioned semiconductor chip with a bonding wire. The connecting step, as shown in Figure 1 (c), includes the step of electrically connecting a tip end of the terminal portion **11b** (inner lead) of the above-mentioned lead frame **10** and an electrode pad **15a** on the above-mentioned semiconductor chip **15** with a bonding wire **16**.

As the bonding wire **16**, for example, a gold wire, an aluminum wire, or the like can be used. In general, the connection is made using vibration energy with ultrasonication together with self-sealing energy with applied pressure in a heated state of 120° to 250°C. During the connection, a side of the heat-resistant adhesive tape **20** adhered to the lead frame **10** is subjected to vacuum suction, whereby the adhesive tape **20** can be surely fixed to a heated block. Here, an embodiment of carrying out the connecting step including the step of subjecting the semiconductor chip **15** to face-up mounting is illustrated hereinabove. In a case where a semiconductor chip **15** is subjected to face-down mounting, a reflow step can be properly carried out.

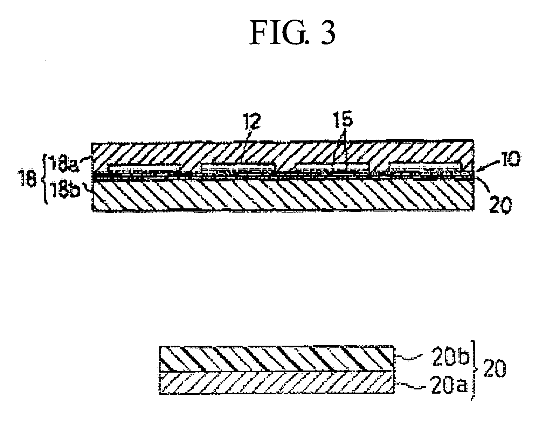

The encapsulating step, as shown in Figure 1 (d), includes the step of subjecting a semiconductor chip **15** side to a single-sided encapsulation with an encapsulating resin **17**. The encapsulating step is carried out for protecting a semiconductor chip **15** or a bonding wire **16** mounted on the lead frame **10**. Representatively, the encapsulating step is carried out by molding in a die using an encapsulating resin **17** typically including an epoxy resin. During the encapsulating step, as shown in Figure 3, generally, the encapsulating step is simultaneously carried out in plural encapsulating resins **17** using a die **18** comprising an upper die **18a** and a lower die **18b.** Specifically, the heating temperature during the resin encapsulation is, for example, from 170° to 180°C, at which temperature the resin is cured for several minutes, and thereafter the cured product is subjected to a post-mold cure for several hours. Here, it is preferable that the heat-resistant adhesive tape **20** is removed before the post-mold cure.

The dicing step, as shown in Figure 1 (e), includes the step of dicing the encapsulated constructed product **21** to individual semiconductor devices **21a**. Generally, the dicing step includes a dicing step including the step of cutting a diced portion **17a** of an encapsulating resin **17** with a rotating dicing blade such as a dicer.

The heat-resistant adhesive tape **20** of the present invention at least comprises a substrate layer (**20a**), and an adhesive layer (**20b**) containing a hydrophilic layered silicate and an adhesive.

Since the heat-resistant adhesive tape **20** is previously adhered to the lead frame **10**, the adhesive tape **20** would be heated in the manufacturing steps mentioned above. For example, in a case where a semiconductor chip **15** is subjected to die bonding, thermal curing is generally carried out at a temperature of from 150°to 200°C or so for 30 to 90 minutes or so. In a case where wire bonding is carried out, the thermal curing is carried out at a temperature, for example, of from 120° to 250°C or so. In a case where many semiconductor devices are manufactured from a single piece of a lead frame 10, as a time period up to termination of bonding for all the semiconductor devices, it is considered that it takes one or more hours for a single piece of the lead frame. Further, in a case where resin encapsulation is carried out, a temperature of 175°C or so is to be applied from the necessity to have a temperature at which the resins are sufficiently melted. Therefore, in the substrate layer of the heat-resistant adhesive tape 20, a material satisfying heat resistance under heating conditions as mentioned above is used.

As described above, in the present invention, as a heat-resistant adhesive tape, one provided with a substrate layer having heat resistance is used. For this reason, the heat-resistant adhesive tape is less likely to generate bowing due to thermal expansion or removal from the lead frame, even when heated in the connecting step or the like. In addition, the heat-resistant adhesive tape can exhibit a high sealing effect. Therefore, when the heat-resistant adhesive tape as described above is put to an outer pad side of the lead frame, the parts opened in the lead frame can also surely be clogged. As a result, the encapsulating resin usable in the encapsulating step can be prevented from leakage from the opening portions, and the like. Therefore, the semiconductor devices can be manufactured with improved yields by using the heat-resistant adhesive tape of the present invention.

### EXAMPLES

The following examples further describe and demonstrate embodiments of the present invention. The examples are given solely for the purposes of illustration and are not to be construed as limitations of the present invention.

The constitution and the effects of the present invention will be explained hereinbelow by means of specifically illustrating Examples and the like.

### Example 1

A polyimide film having a thickness of 25 µm (Kapton 100H commercially available from DUPONT-TORAY CO., LTD.) was used as a substrate layer. An acrylic adhesive composition containing a copolymer emulsion prepared by adding 2 parts by weight of a monomer acrylic acid and 2 parts by weight of an emulsifying agent sodium polyoxyethylene lauryl sulfate to 100 parts of n-butyl acrylate containing 20 parts by weight of a hydrophilic layered silicate, synthetic smectite (LUCENTITE SPN commercially available from CO-OP CHEMICAL CO., LTD., average particle size: 50 nm) was used. Further, an epoxy-based cross-linking agent (Tetad-C commercially available from MITSUBISHI GAS CHEMICAL COMPANY, INC.) was added to the acrylic adhesive composition in an amount of 0.5 parts by weight, based on 100 parts by weight of this acrylic adhesive composition, to prepare a water-dispersible acrylic adhesive. Using this water-dispersible acrylic adhesive containing the hydrophilic layered silicate and the copolymer emulsion, a heat-resistant adhesive tape comprising an adhesive layer having a thickness of 10 µm was produced. This water-dispersible acrylic adhesive containing the hydrophilic layered silicate and the copolymer emulsion was measured for shearing storage modulus with ARES commercially available from T A Instruments, Japan (formerly known as Rheometric Scientific) in the mode of shearing storage modulus with parallel plates having a sample size of 7.9 mm in diameter at a frequency of 1 Hz and a heating rate of 5°C/minute. As a result, the water-dispersible acrylic adhesive had a shearing storage modulus of 1.0 × 10⁶ Pa at 200°C. Also, this resulting heat-resistant adhesive tape had an adhesive strength of 0.32 N/19 mm width at 175°C. This heat-resistant adhesive tape had an adhesive strength of 2.5 N/19 mm width at 23°C as determined by a method according to JIS Z 0237 in a case where a side of the adhesive layer was adhered to a stainless plate and heated at 200°C for 1 hour.

This heat-resistant adhesive tape was put on an outer pad side of the lead frame made of copper in which QFN of 16 pins per side plated with Ni/Pd and flash Au were arranged in four by four. A semiconductor chip was bonded to a die pad portion of this lead frame using an epoxy phenol-based silver paste, and cured at 180°C for 1 hour or so to fix the semiconductor chips.

Next, the lead frame was affixed to a heated block heated to 200°C by way of vacuum suction from a heat-resistant adhesive tape side, and the peripheral parts of the lead frame were affixed by pressing with a wind clamper. The affixed lead frame was subjected to wire bonding under conditions with a gold line (GMG-25 commercially available from Tanaka Kikinzoku Kogyo) having a diameter of 25 µm with a 115 kHz wire bonder (UTC-300BIsuper commercially available from SHINKAWA LTD.). Here, it took about 1 hour to complete all the bonding.

First bonding pressure: 80 g, first bonding ultrasonic intensity: 550 mW, applied time for first bonding: 10 msec, second bonding pressure: 80 g, second bonding ultrasonic intensity: 500 mW, and applied time for second bonding: 8 msec.

Further, an epoxy-based encapsulating resin (HC-300B6, commercially available from NITTO DENKO CORPORATION) was added thereto, and the resulting encapsulating resin-added lead frame after wire bonding was molded with a molding machine (Model: Y-Series, commercially available from TOWA Corporation) under conditions of 175°C, a preheating setting of 3 seconds, an injection time of 12 seconds, and a cure time of 90 seconds. Thereafter, the heat-resistant adhesive tape was removed from the lead frame. The resin was subjected to a post mold-curing at 175°C for additional 2 hours or so to sufficiently cure the resin. Thereafter, the resulting cured product was diced with a dicer, to give individual QFN-type semiconductor devices.

The QFNs thus obtained had high adhesive strength at high temperatures, so that the heat-resistant adhesive tape could be easily removed without leaving any pasty residues. Also, the QFNs had excellent masking ability of suppressing leakage of the encapsulating resin, so that an excellent package in which especially notable adhesion stains and the like were not found in the perfected package could be obtained, whereby the amount of gas generated could be suppressed.

### Comparative Example 1

The resin encapsulation was carried out in the same manner as in Example 1 by bonding a semiconductor chip to a lead frame alone without adhesion of a heat-resistant adhesive tape, and inserting between a mold. As a result, the resin leakage was generated.

### Comparative Example 2

In the preparation of the water-dispersible acrylic adhesive containing a copolymer emulsion in Example 1, a water-dispersible acrylic adhesive containing a copolymer emulsion having the same composition as in Example 1 except that a hydrophilic layered silicate was not added was prepared. In addition, a heat-resistant adhesive tape was produced in the same manner as in Example 1 using the resulting water-dispersible acrylic adhesive containing the copolymer emulsion, and QFNs were manufactured in the same manner as in Example 1. In the QFNs thus obtained, the resin leakage was generated before the step of resin encapsulation. Here, the shearing storage modulus of the water-dispersible acrylic adhesive containing the copolymer emulsion, as determined in the same manner as in Example 1, was 8.0 × 10⁵ Pa, the adhesive strength of this adhesive tape was 0.05 N/19 mm width at 175°C, and the adhesive strength of this adhesive tape was 3.0 N/19 mm width at 23°C in a case where a side of the adhesive layer is adhered to a stainless plate and heated at 200°C for 1 hour.

The present invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A heat-resistant adhesive tape for manufacturing a semiconductor device usable in a method for manufacturing a semiconductor device comprising at least the steps of mounting a semiconductor chip on a die pad of a metallic lead frame in which a heat-resistant adhesive tape is adhered to an outer pad side to bond the semiconductor chip thereto, subjecting a semiconductor chip side to a single-sided encapsulation with an encapsulating resin, and dicing the encapsulated constructed product to individual semiconductor devices, **characterized in that** the heat-resistant adhesive tape comprises a substrate layer, and an adhesive layer comprising a hydrophilic layered silicate and an adhesive.

2. The heat-resistant adhesive tape according to claim 1, wherein the adhesive layer comprises a hydrophilic layered silicate in an amount of 40 parts by weight or less, based on 100 parts by weight of the adhesive.

3. The heat-resistance adhesive tape according to claim 1, wherein the adhesive layer comprises a water-dispersible acrylic adhesive comprising a copolymer emulsion obtained by carrying out emulsion polymerization in the presence of an emulsifying agent.

4. The heat-resistance adhesive tape according to claim 2, wherein the adhesive layer comprises a water-dispersible acrylic adhesive comprising a copolymer emulsion obtained by carrying out emulsion polymerization in the presence of an emulsifying agent.

5. The heat-resistant adhesive tape according to any one of claims 1 to 4, wherein the adhesive layer has an adhesive strength of 0.2 N/19 mm width or more at 175°C in a case where a side of the adhesive layer is adhered to a stainless plate.

6. The heat-resistant adhesive tape according to any one of claims 1 to 4, wherein the adhesive layer has an adhesive strength of 5.0 N/19 mm width or less at 23 °C in a case where a side of the adhesive layer is adhered to a stainless plate and heated at 200°C for 1 hour.
